# EUROPÄISCHE PATENTSCHRIFT

(11) **EP 1 095 822 B1**
(45) Veröffentlichungstag und Bekanntmachung des Hinweises auf die Patenterteilung: **23.07.2003**
(21) Anmeldenummer: 00122341.1
(22) Anmeldetag: 23.10.2000
(51) Int. Cl.: B60R 21/01, B60R 16/02, H05K 5/00

(54) **Steuergerät für Insassen-Rückhaltesystem in Fahrzeugen**
Air bag control unit
Appareil de commande d'airbag

(30) Priorität: 27.10.1999 DE 29918914 U
(43) Veröffentlichungstag der Anmeldung: 02.05.2001
(73) Patentinhaber: TRW Automotive Electronics & Components GmbH & Co. KG, 78304 Radolfzell (DE)
(72) Erfinder: Skofljanec, Robert, 78345 Moos-Bankholzen (DE)
(74) Vertreter: Degwert, Hartmut, Dipl.-Phys.

(56) Entgegenhaltungen:
- DE-A- 4 300 342
- DE-U- 29 617 603

## Beschreibung

Die Erfindung betrifft ein Steuergerät für ein Insassen-Rückhaltesystem in Fahrzeugen, mit einem eine metallische Grundplatte aufweisenden Gehäuse und einem auf einer Leiterplatte aufgebauten, einen Beschleunigungssensor umfassenden Elektronikmodul, das in das Gehäuse einsetzbar ist, wie es aus DE-A-4 300 342 bekannt ist.

Von der sicheren und zuverlässigen Funktion eines solchen Steuergerätes hängt die Wirksamkeit der daran angeschlossenen Rückhaltesysteme, wie Gurtstraffer und Airbag, ab. Das Gehäuse eines solchen Steuergerätes muß daher einen sicheren Schutz für das Elektronikmodul gegen Beeinträchtigungen jeglicher Art gewährleisten. Darüber hinaus hat aber das starr mit dem Fahrzeugaufbau verschraubte Gehäuse die Funktion, die bei einem Fahrzeugaufprall auftretenden Verzögerungen möglichst direkt auf den Beschleunigungssensor des Elektronikmoduls zu übertragen. Es werden daher für das Gehäuse massive metallische Ausführungen verwendet, insbesondere schwere Aluminium-Druckguß-Gehäuse. Es wurden auch schon Gehäuse aus Kunststoff vorgeschlagen, bei denen dann an den Befestigungsstellen der Grundplatte umspritzte Befestigungsbuchsen aus Metall vorgesehen wurden, da Kunststoff-Werkstoffe dem Anpreßdruck der Verschraubung nicht standhalten können. Die Steifigkeit und Starrheit einer solchen Gehäuseausführung ist aber nur befriedigend.

Durch die Erfindung wird ein Steuergerät geschaffen, dessen Gehäuse die mechanischen Vorzüge einer metallischen Ausführung mit den herstellungstechnischen und Kostenvorteilen einer Kunststoffausführung in sich vereint. Gemäß der Erfindung ist das Gehäuse als Verbundkörper aus einem durch Spritzgießen hergestellten Kunststoffkörper und der mindestens bereichsweise mit Kunststoffmasse umspritzten Grundplatte ausgebildet. Die metallische Grundplatte sorgt für die starre Ankopplung an den Fahrzeugaufbau. Da die Leiterbahn, auf welcher der Beschleunigungssensor aufgebaut ist, unmittelbar über der Grundplatte angeordnet wird, ist eine direkte Impulsübertragung von der Grundplatte zum Beschleunigungssensor gewährleistet. Durch die metallische Grundplatte sind auch die Befestigungspunkte genau definiert, im Gegensatz zu einer Kunststoffausführung des Gehäuses mit umspritzten Befestigungsbuchsen, deren Abstände durch Schrumpfen des Kunststoffmaterials verändert werden. Gegenüber einer Ausführung mit umspritzten Metallbuchsen hat die erfindungsgemäße Lösung weiterhin den Vorteil der vereinfachten Herstellung, da das Einlegen der metallischen Grundplatte in die Kunststofform sehr viel einfacher geschehen kann als die korrekte Anordnung der einzelnen Befestigungsbuchsen.

Bei der bevorzugten Ausführungsform wird die metallische Grundplatte elektrisch leitend mit der Masse der Leiterplatte verbunden. Dazu dient eine elektrisch leitende Brücke, die in verschiedenen Ausführungsvarianten vorgesehen sein kann und von der Grundplatte zu einem Kontaktstift oder einer Kontaktfahne an einem Steckersockel und von dort zur Leiterplatte führt.

Ein mechanisch fester und starrer Verbund zwischen der metallischen Grundplatte und dem Kunststoffkörper des Gehäuses wird bei einer vorteilhaften Ausführungsform durch eine Vielzahl von Durchbrechungen der Grundplatte erreicht, die von der Kunststoffmasse formschlüssig durchsetzt sind. Alternativ oder zusätzlich weist die Grundplatte eine Vielzahl von freigestanzten und einwärts gebogenen Laschen auf, die in der Kunststoffmasse eingebettet sind. Ferner ist bei der bevorzugten Ausführungsform die Grundplatte mit der äußeren Bodenfläche des Gehäuses bündig, innenseitig aber von einer Kunststoffschicht bedeckt, so daß die Grundplatte letztlich in den Boden des Gehäusekörpers eingelassen ist.

Gemäß einer Weiterbildung der Erfindung nimmt die metallische Grundplatte nur einen Teilbereich der Bodenfläche des Gehäuses ein, insbesondere eine durch eine Diagonallinie abgegrenzte Hälfte der Bodenfläche des Gehäuses. Es wurde gefunden, daß auch bei einer solchen material- und gewichtssparenden Ausführung des Gehäuses ein hinreichend starrer Verbund und eine gute mechanische Kopplung zwischen Grundplatte und Beschleunigungssensor gewährleistet sind.

Weitere Vorteile und Merkmale der Erfindung ergeben sich aus der folgenden Beschreibung mehrerer Ausführungsformen und aus den Zeichnungen, auf die Bezug genommen wird. In den Zeichnungen zeigen:
- Figur 1 eine perspektivische Ansicht des Steuergerätes schräg von oben;
- Figur 2 eine Draufsicht auf die Grundplatte des Gehäuses von unten;
- Figur 3 eine Schnittansicht entlang Linie III-III in Figur 2;
- Figur 4 einen vergrößerten Ausschnitt aus Figur 3;
- Figuren 5 bis 8 verschiedene Ausführungsvarianten einer elektrischen Massebrücke zwischen der Grundplatte des Gehäuses und einem mit der Leiterplatte des Elektronikmoduls verbundenen Kontaktstift;
- Figur 9 eine vorteilhafte Weiterbildung des Steuergerätes in teilweise geschnittener Perspektivansicht; und
- Figur 10 eine Detailansicht im Bodenbereich des Gehäuses.

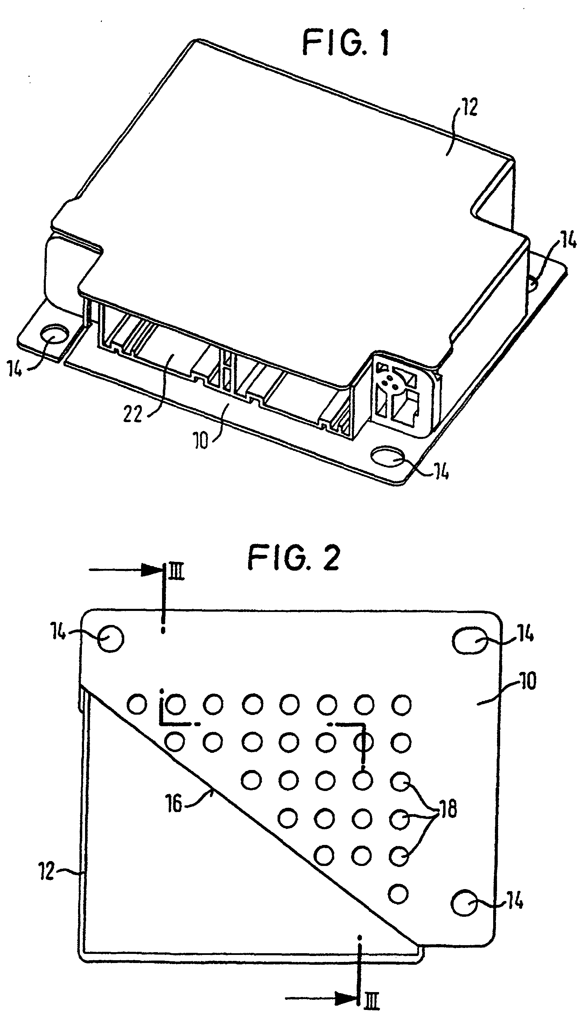

Das Gehäuse des Steuergerätes besteht aus einer metallischen ebenen Grundplatte 10 und einem haubenförmigen Kunststoffkörper 12, der allgemein quaderförmig ist. Die Grundplatte 10 hat über den Kunststoffkörper 12 hinausragende Randstreifen, an deren drei Ecken Befestigungsöffnungen 14 angeordnet sind. Wie aus Figur 2 ersichtlich ist, nimmt die Grundplatte 10 nur einen Teil der Bodenfläche des Gehäuses ein. Der Teilbereich der Bodenfläche des Gehäuses, den die Grundplatte 10 einnimmt, ist durch eine Diagonallinie 16 abgegrenzt. Die Grundplatte 10 nimmt somit nur etwa die Hälfte der Bodenfläche des Gehäuses ein.

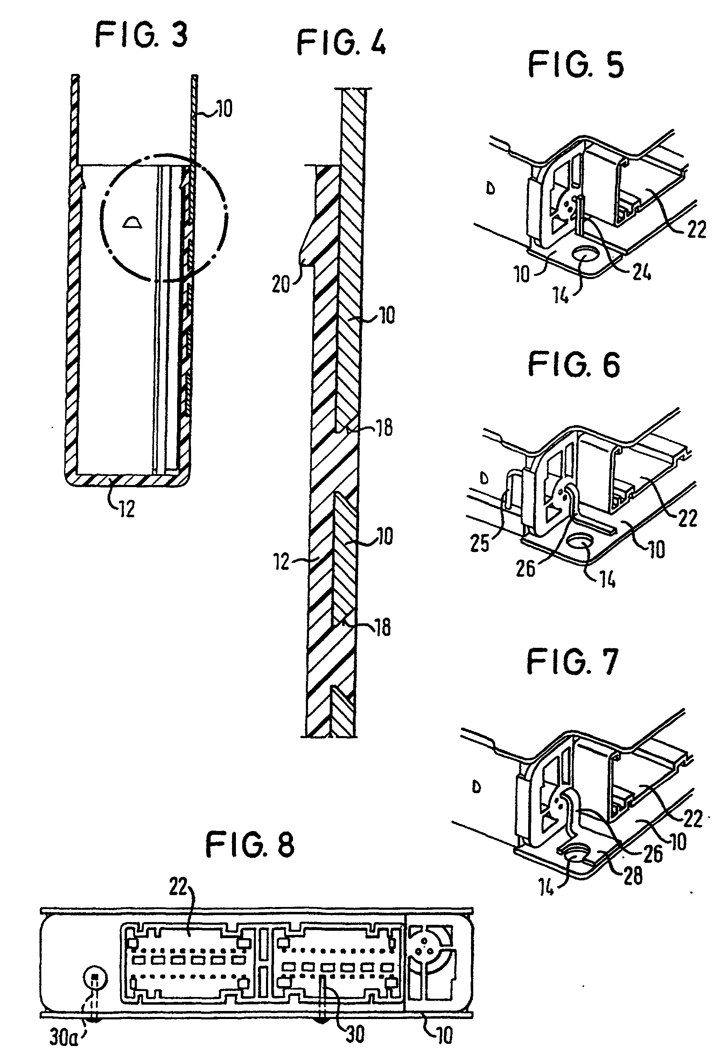

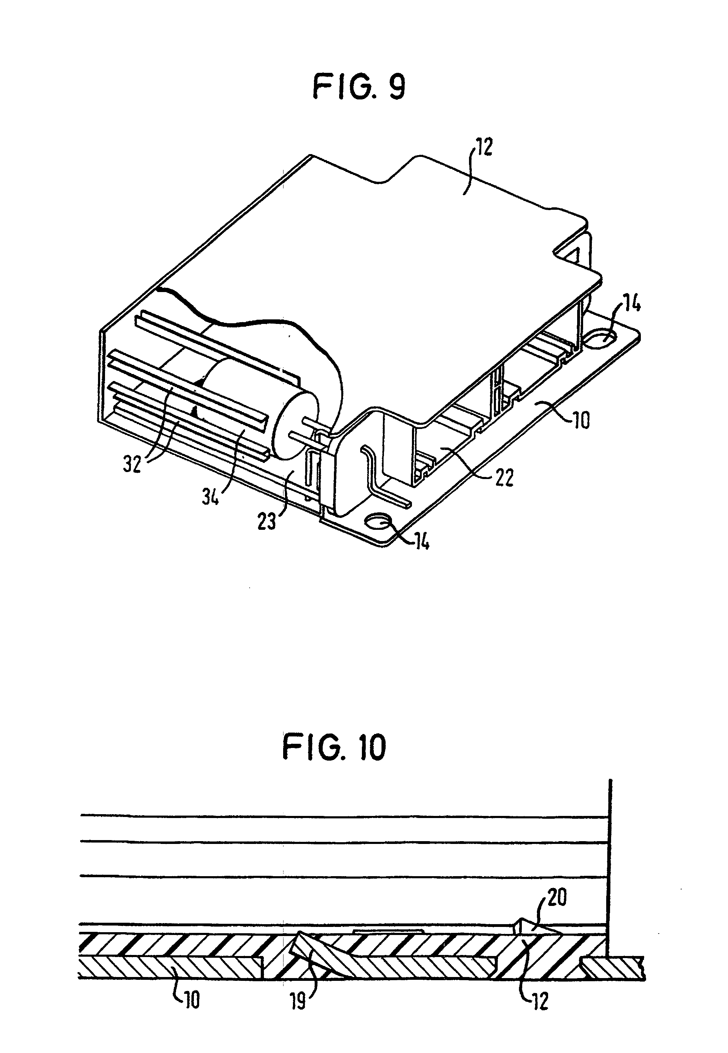

Die Herstellung des Gehäuses erfolgt durch Spritzgießen in einer Form, in welche zuvor die Grundplatte 10 eingelegt wird. Die Grundplatte 10 hat eine Vielzahl von Durchbrechungen 18, die zur Außenseite hin kegelförmig erweitert sind. Die Figuren 3 und 4 zeigen, wie die Grundplatte 10 beim Spritzvorgang mit dem Kunststoffkörper des Gehäuses in Verbund gebracht wird. Die Grundplatte 10 ist außenseitig mit der Bodenfläche des Gehäuses bündig. Innenseitig ist die Grundplatte 10 von einer Kunststoffschicht bedeckt, deren Dicke ungefähr der Dicke der Grundplatte entspricht. Die Durchbrechungen 18 der Grundplatte 10 sind von der Kunststoffmasse formschlüssig durchsetzt. Zusätzlich oder alternativ weist die Grundplatte eine Vielzahl von freigestanzten und einwärts gebogenen Laschen 19 (Figur 10) auf, die in der Kunststoffmasse eingebettet sind. Innenseitig sind an den Kunststoffkörper 12 Rastnasen 20 oder Rastkerben angespritzt, deren Funktion noch zu erläutern ist.

Das Gehäuse hat eine offene Schmalseite, in die ein rahmenförmiger Steckersockel 22 aus Kunststoff eingesetzt wird, wodurch diese offene Gehäuseseite verschlossen wird. Der Steckersockel 22 ist durch eine Vielzahl von Kontaktstiften und durch Rastmittel mit einer Leiterplatte 23 (Figur 9) verbunden, auf welcher das Elektronikmodul des Steuergeräts mit einem Beschleunigungssensor aufgebaut ist. Das komplette, aus Steckersockel 22 und Leiterplatte 23 bestehende Elektronikmodul wird in das Gehäuse eingeschoben, wobei die Leiterplatte in innenseitig in das Gehäuse eingeformten Führungsschlitzen aufgenommen wird. Durch die innenseitig am Gehäuse angespritzten Rastnasen 20, die am Steckersockel 22 angreifen, wird das Elektronikmodul mit dem Gehäuse sicher verrastet. Durch einen Dichtring aus Silikongummi wird das Gehäuse am Übergang zum Steckersockel 22 abgedichtet. Alternativ sind die Rastnasen am Steuersockel 22 angeformt und das Gehäuse weist entsprechende Rastkerben auf.

Um eine elektrische Verbindung zwischen der Grundplatte und der Masse auf der Leiterplatte des Elektronikmoduls herzustellen, ist eine elektrisch leitende Brücke vorgesehen. Vier Ausführungsvarianten dieser elektrisch leitenden Brücke sind in den Figuren 5 bis 8 dargestellt.

Bei der in Figur 5 gezeigten Ausführungsform ist aus der Grundplatte 10 neben einer der Befestigungsöffnungen 14 eine Lasche 24 freigestanzt und rechtwinklig hochgebogen. Das freie Ende dieser Lasche 24 ist, beispielsweise durch Schweißen oder Löten, mit dem Ende eines Kontaktstiftes verbunden, der den Steckersockel 22 durchragt und innenseitig auf der Leiterplatte verlötet ist.

Bei der in Figur 6 gezeigten Ausführungsform ist ein auf der Leiterplatte verlöteter Kontaktstift 25 durch den Steckersockel 22 geführt und als Kontaktlamelle 26 zur Grundplatte 10 hin abgebogen und dort flächig befestigt, beispielsweise durch Schweißen oder Löten.

Bei der in Figur 7 gezeigten Ausführungsform ist das Ende der Kontaktlamelle 26 als Kontaktschuh 28 ausgebildet, der ganz oder teilweise mit einer Befestigungsöffnung 14 zur Deckung gebracht und bei der Verschraubung zwischen Schraubenkopf und Grundplatte 10 eingeklemmt wird.

Bei der Ausführungsform nach Figur 8 ist ein Kontaktstift 30 mit einem freien Ende an der Grundplatte 10 durch Schweißen oder Nieten befestigt; das andere Ende des Kontaktstiftes 30 ist mit einem aus dem Steckersockel 22 herausragenden Kontaktstift verbunden. Der Kontaktstift 30 bildet zugleich eine mechanische Sicherung, die ein Lösen des Steckersockels 22 aus dem Gehäuse erschwert. Alternativ ist in Figur 8 eine Anordnung des Kontaktstiftes bei 30a gezeigt. Es können auch mehrere derartige Kontaktstifte vorgesehen werden.

Bei der in Figur 9 gezeigten Weiterbildung des Steuergerätes sind innenseitig am Kunststoffkörper 12 des Gehäuses Führungs- und Stützschienen 32 angeformt, die sich in Einschubrichtung des die Leiterplatte 23 mit Steckersockel 22 umfassenden Elektronikmoduls erstrecken. Zwischen diesen Führungs- und Stützschienen 32 ist ein Bauteil 34 wie ein zylindrischer Kondensator einschiebbar. Dieses Bauteil 34 ist freitragend an dem Steckersockel 22 oder der Leiterplatte 23 montiert sowie elektrisch kontaktiert und wird erst durch die Führungs- und Stützschienen 32 lasttragend im Gehäuse gestützt und in seiner Position gesichert.

## Patentansprüche

1. Steuergerät für ein Insassen-Rückhaltesystems in Fahrzeugen, mit einem eine metallische Grundplatte (10) aufweisenden Gehäuse und einem auf einer Leiterplatte (23) aufgebauten, einen Beschleunigungssensor umfassenden Elektronikmodul, das in das Gehäuse einsetzbar ist, **dadurch gekennzeichnet, daß** das Gehäuse als Verbundkörper aus einem durch Spritzgießen hergestellten Kunststoffkörper (12) und der mindestens bereichsweise mit Kunststoffmasse umspritzten Grundplatte (10) ausgebildet ist.

2. Steuergerät nach Anspruch 1, **dadurch gekennzeichnet, daß** die Grundplatte (10) eine Vielzahl von Durchbrechungen (18) aufweist, die von der Kunststoffmasse formschlüssig durchsetzt sind.

3. Steuergerät nach Anspruch 2, **dadurch gekennzeichnet, daß** die Durchbrechungen (18) der Grundplatte (10) außenseitig erweitert sind.

4. Steuergerät nach einem der vorstehenden Ansprüche, **dadurch gekennzeichnet, daß** die Grundplatte (10) eine Vielzahl von freigestanzten und einwärts gebogenen Laschen (19) aufweist, die in der Kunststoffmasse eingebettet sind.

5. Steuergerät nach einem der vorstehenden Ansprüche, **dadurch gekennzeichnet, daß** die Grundplatte (10) mit der äußeren Bodenfläche des Gehäuses bündig abschließt und innenseitig von einer Kunststoffschicht bedeckt ist.

6. Steuergerät nach einem der vorstehenden Ansprüche, **dadurch gekennzeichnet, daß** die metallische Grundplatte (10) nur einen Teilbereich der Bodenfläche des Gehäuses einnimmt.

7. Steuergerät nach Anspruch 6, **dadurch gekennzeichnet, daß** die Grundplatte (10) im wesentlichen eine durch eine Diagonallinie (16) abgegrenzte Hälfte der Bodenfläche des Gehäuses einnimmt.

8. Steuergerät nach einem der vorstehenden Ansprüche, **dadurch gekennzeichnet, daß** das Gehäuse eine offene Schmalseite aufweist, die durch einen mit der Leiterplatte (23) verbundenen Steckersockel (22) verschlossen ist.

9. Steuergerät nach Anspruch 8, **dadurch gekennzeichnet, daß** der Stekkersockel (22) durch innenseitig an die Wandung des Gehäuses angespritzte Rastelemente (20) verrastet ist.

10. Steuergerät nach einem der vorstehenden Ansprüche, **dadurch gekennzeichnet, daß** innenseitig in einander gegenüberliegenden Schmalseitenwänden des Gehäuses Führungsnuten für die Leiterplatte (23) eingeformt sind.

11. Steuergerät nach einem der vorstehenden Ansprüche, **dadurch gekennzeichnet, daß** die Grundplatte (10) das Gehäuse auf zwei Seiten überragt und an den überragenden Randstreifen Befestigungsöffnungen (14) aufweist.

12. Steuergerät nach einem der vorstehenden Ansprüche, **dadurch gekennzeichnet, daß** eine elektrisch leitende Brücke zwischen der Grundplatte (10) und der Leiterplatte (23) ausgebildet ist.

13. Steuergerät nach Anspruch 12, **dadurch gekennzeichnet, daß** die elektrisch leitende Brücke durch eine aus der Grundplatte (10) freigestanzte und in Richtung der Leiterplatte (23) hochgebogene Lasche (24) gebildet ist.

14. Steuergerät nach Anspruch 1, **dadurch gekennzeichnet, daß** die Lasche (24) mit einem aus einem Steckersockel (22) herausragenden Kontaktstift verbunden ist.

15. Steuergerät nach Anspruch 12, **dadurch gekennzeichnet, daß** die Brücke durch einen die Grundplatte (10) und einen Steckersockel (22) durchdringenden Kontaktstift (25) gebildet ist, der direkt mit der Leiterplatte (23) verbunden ist.

16. Steuergerät nach Anspruch 12, **dadurch gekennzeichnet, daß** die Brücke durch eine Kontaktfahne (26) gebildet ist, die von der Grundplatte (10) durch einen Steckersockel (22) in das Innere des Gehäuses bis zur Leiterplatte (23) geführt ist.

17. Steuergerät nach einem der vorstehenden Ansprüche, **dadurch gekennzeichnet, daß** der Kunststoffkörper (12) durch Fasermaterial, insbesondere Glasfasern, verstärkt ist.

18. Steuergerät nach einem der vorstehenden Ansprüche, **dadurch gekennzeichnet, daß** innenseitig am Kunststoffkörper (12) des Gehäuses Führungs- und Halterungsstrukturen für wenigstens ein Bauteil (34) angeformt sind, das elektrisch und/oder mechanisch mit der Leiterplatte (23) oder einem eine Schmalseite des Gehäuses verschließenden Stekkersockel (22) verbunden ist.

## Claims

1. A control device for a vehicular occupant restraint system, comprising a housing having a metallic base plate (10) and an electronic module including an acceleration sensor and mounted on a circuit board (23), the electronic module being adapted to be inserted in the housing, **characterized in that** the housing is formed as a composite of an injection-molded plastic body (12) and of the base plate (10) encased at least in part with an injection-molded plastic compound.

2. The control device as set forth in claim 1, **characterized in that** the base plate (10) has a plurality of through-holes (18) which are filled with the plastic compound in a form-fitting manner.

3. The control device as set forth in claim 2, **characterized in that** the through-holes (18) of the base plate (10) are flared outwardly.

4. The control device as set forth in any of the preceding claims, **characterized in that** the base plate (10) comprises a plurality of stamped-out and inwardly bent tabs (19) embedded in the plastic compound.

5. The control device as set forth in any of the preceding claims, **characterized in that** the base plate (10) is flush with the outer bottom surface area of the housing and is covered on the inside by a plastic coating.

6. The control device as set forth in any of the preceding claims, **characterized in that** the metallic base plate (10) takes up only part of the bottom surface area of the housing.

7. The control device as set forth in claim 6, **characterized in that** the base plate (10) takes up substantially half of the bottom surface area of the housing as defined by a diagonal line (16).

8. The control device as set forth in any of the preceding claims, **characterized in that** the housing comprises an open narrow side closed off by a plug base (22) connected to the circuit board (23).

9. The control device as set forth in claim 8, **characterized in that** the plug base (22) is locked in place by latching elements (20) injection-molded to the inside of the housing wall.

10. The control device as set forth in any of the preceding claims, **characterized in that** guide grooves for the circuit board (23) are incorporated on the inside of opposing narrow sidewalls of the housing.

11. The control device as set forth in any of the preceding claims, **characterized in that** the base plate (10) protrudes beyond the housing on two sides and comprises fastening holes (14) in the protruding edge strips.

12. The control device as set forth in any of the preceding claims, **characterized in that** an electrically conducting link is configured between the base plate (10) and the circuit board (23).

13. The control device as set forth in claim 12, **characterized in that** the electrically conducting link is formed by a tab (24) stamped out from the base plate (10) and bent up towards the circuit board (23).

14. The control device as set forth in claim 1, **characterized in that** the tab (24) is connected to a contact pin protruding from a plug base (22).

15. The control device as set forth in claim 12, **characterized in that** the link is formed by a contact pin (25) passing through the base plate (10) and a plug base (22), the contact pin being directly connected to the circuit board (23).

16. The control device as set forth in claim 12, **characterized in that** the link is formed by a contact tag (26) guided from the base plate (10) through a plug base (22) into the interior of the housing up to the circuit board (23).

17. The control device as set forth in any of the preceding claims, **characterized in that** the plastic body (12) is reinforced by fiber material, more particularly glass fibers.

18. The control device as set forth in any of the preceding claims, **characterized in that** structures for guiding and retaining at least one component (34) are integrally molded on the inside of the plastic body (12) of the housing, the component being connected electrically and/or mechanically to the circuit board (23) or to a plug base (22) closing off a narrow side of the housing.

## Revendications

1. Appareil de commande pour un système de retenue d'occupants dans des véhicules, comportant un boîtier présentant une plaque de base (10) métallique et un module électronique monté sur une carte de circuits imprimés (23) et comprenant un capteur d'accélération qui peut être inséré dans le boîtier, **caractérisé en ce que** le boîtier est réalisé sous forme de corps composite par un corps de matière plastique (12), fabriqué par moulage par injection, et par la plaque de base (10) enrobée au moins en partie de matière plastique.

2. Appareil de commande selon la revendication 1, **caractérisé en ce que** la plaque de base (10) présente une multitude de trous traversants qui sont remplis de la matière plastique par coopération de formes.

3. Appareil de commande selon la revendication 2, **caractérisé en ce que** les trous traversants (18) de la plaque de base (10) sont évasés sur la face extérieure.

4. Appareil de commande selon l'une des revendications précédentes, **caractérisé en ce que** la plaque de base (10) présente une multitude de languettes (19) dégagées par estampage et repliées vers l'intérieur, qui sont noyées dans la masse de matière plastique.

5. Appareil de commande selon l'une des revendications précédentes, **caractérisé en ce que** la plaque de base (10) est en affleurement avec la surface de fond extérieure du boîtier et recouverte sur la face intérieure par une couche de matière plastique.

6. Appareil de commande selon l'une des revendications précédentes, **caractérisé en ce que** la plaque de base (10) métallique n'occupe qu'une région partielle de la surface de fond du boîtier.

7. Appareil de commande selon la revendication 6, **caractérisé en ce que** la plaque de base (10) occupe sensiblement une moitié de la surface de fond du boîtier limitée par une ligne diagonale (16).

8. Appareil de commande selon l'une des revendications précédentes, **caractérisé en ce que** le boîtier présente un petit côté ouvert qui est fermé par un socle à fiches (22) relié à la carte de circuits imprimés (23).

9. Appareil de commande selon la revendication 8, **caractérisé en ce que** le socle à fiches (22) est enclenché par des éléments d'enclenchement (20) moulés par injection sur la face intérieure de la paroi du boîtier.

10. Appareil de commande selon l'une des revendications précédentes, **caractérisé en ce que** des gorges de guidage pour la carte de circuits imprimés (23) sont formées à l'intérieur dans des petits côtés du boîtier, opposés l'un à l'autre.

11. Appareil de commande selon l'une des revendications précédentes, **caractérisé en ce que** la plaque de base (10) dépasse le boîtier sur deux côtés et présente des ouvertures de fixation (14) sur les bandes de bordure en dépassement.

12. Appareil de commande selon l'une des revendications précédentes, **caractérisé en ce qu'**un pont électroconducteur est réalisé entre la plaque de base (10) et la carte de circuits imprimés (23).

13. Appareil de commande selon la revendication 12, **caractérisé en ce que** le pont électroconducteur est formé par une languette (24) dégagée par estampage hors de la plaque de base (10) et repliée vers le haut en direction de la carte de circuits imprimés (23).

14. Appareil de commande selon la revendication 1, **caractérisé en ce que** la languette (24) est reliée à une fiche de contact faisant saillie hors d'un socle à fiches (22).

15. Appareil de commande selon la revendication 12, **caractérisé en ce que** le pont est formé par une fiche de contact (25) traversant la plaque de base (10) et un socle à fiches (22), la fiche de contact étant directement reliée à la carte de circuits imprimés (23).

16. Appareil de commande selon la revendication 12, **caractérisé en ce que** le pont est formé par une plaquette de contact (26) qui est guidée depuis la plaque de base (10) à travers un socle à fiches (22) à l'intérieur du boîtier jusqu'à la carte de circuits imprimés (23).

17. Appareil de commande selon l'une des revendications précédentes, **caractérisé en ce que** le corps de matière plastique (12) est renforcé par du matériau à fibres, en particulier par des fibres de verre.

18. Appareil de commande selon l'une des revendications précédentes, **caractérisé en ce que** sur la face intérieure du corps de matière plastique (12) du boîtier, des structures de guidage et de maintien sont formées pour au moins un composant (34) qui est relié électriquement et/ou mécaniquement à la carte de circuits imprimés (23) ou à un socle à fiches (22) fermant un petit côté du boîtier.
